# FASCICULE DE BREVET EUROPEEN

(11) **EP 0 674 264 B1**
(45) Date de publication et mention de la délivrance du brevet: **22.01.1997**
(21) Numéro de dépôt: 95460007.8
(22) Date de dépôt: 17.02.1995
(51) Int. Cl.: G06F 11/20

(54) **Circuit de sélection d'éléments de mémoire redondants et mémoire "FLASH EEPROM" comportant ledit circuit**
Schaltung zum Wählen von Redundanzspeicherbauelementen und diese enthaltende FLASH EEPROM
Circuit for selecting redundant memory elements and FLASH EEPROM containing said circuit

(30) Priorité: 23.02.1994 FR 9402304
(43) Date de publication de la demande: 27.09.1995
(73) Titulaire: SGS-THOMSON MICROELECTRONICS S.A., 94250 Gentilly (FR)
(72) Inventeur: Gaultier, Jean-Marie Bernard, F-56100 Lorient (FR)
(74) Mandataire: Dubreuil, Annie

(56) Documents cités:
- EP-A- 0 383 452
- GB-A- 2 254 173
- US-A- 5 034 925
- US-A- 5 281 868

## Description

L'invention se situe principalement dans le domaine des mémoires intégrées non volatiles effaçables électriquement et concerne plus particulièrement les mémoires de type "FLASH EEPROM".

De façon habituelle, les mémoires sont commercialisées pour une capacité donnée, par exemple 16 mégabits pour une "FLASH EEPROM". Or, les procédés de fabrication des circuits intégrés introduisent très souvent des défauts, notamment ceux qui affectent les cellules mémoire. Aussi, pour éviter un trop grand nombre de rebuts, les concepteurs de ces circuits prévoient un certain nombre de cellules redondantes destinées à remplacer le cas échéant des cellules défectueuses.

Généralement, les mémoires sont organisées en matrices formées de rangées et de colonnes de cellules mémoire. Chaque cellule est alors sélectionnable par une ligne de mot associée à chaque rangée et une ligne de bit associée à chaque colonne. En pratique, pour des raisons de simplicité, le remplacement d'une cellule défectueuse est réalisé en remplaçant la totalité de la rangée ou de la colonne comportant cette cellule. L'élément de mémoire - rangée ou colonne - devant être remplacé dépendra du type de défaut détecté.

Ces éléments redondants sont mis en service à la suite de tests effectués après la fabrication de chaque circuit intégré. Pour cela, des moyens de reconfiguration programmables sont prévus dans le circuit intégré de sorte que, lorsque le test révèle un élément en défaut, ce dernier soit remplacé automatiquement par un élément de remplacement choisi parmi les éléments redondants et ce remplacement doit être invisible et sans conséquence sur les performances de la mémoire. En pratique, les moyens de reconfiguration contiennent des circuits pour détecter si l'adresse courante présentée à la mémoire correspond à celle d'un élément en défaut et, si c'est le cas, ils sélectionnent un élément redondant en remplacement de l'élément en défaut.

Ce remplacement automatique est habituellement effectué au moyen de registres programmables non volatiles prévus pour contenir les adresses des éléments défectueux. Dans le cas d'une mémoire organisée en rangées et colonnes, cette adresse sera soit l'adresse de rangée, soit l'adresse de colonne, correspondant respectivement aux poids forts ou aux poids faibles de l'adresse complète. Jusqu'à présent, chaque élément redondant est associé à un tel registre ainsi qu'à un comparateur qui reçoit en entrées la valeur contenue dans ce registre et l'adresse courante. Lorsque les opérations de tests sont terminées, on programme les registres à des valeurs représentatives des adresses des éléments défectueux. Ainsi, en fonctionnement, si l'adresse courante coïncide avec la valeur contenue d'un des registres, le comparateur associé délivre un signal permettant de sélectionner automatiquement l'élément redondant associé. Parallèlement, la sélection de l'élément défectueux est inhibée.

Cette solution nécessite donc de prévoir un nombre de registres programmables égal au nombre d'éléments redondants. D'autre part, il est nécessaire de programmer autant de registres que d'éléments défectueux détectés. Or, la présence de registres programmables non volatiles pose des problèmes de fiabilité dûs à la difficulté de leur fabrication et de leur programmation.

Aussi, l'invention a pour but d'améliorer la fiabilité en proposant une solution qui limite le nombre des registres programmables, en particulier dans les cas où les éléments défectueux sont topologiquement voisins.

Plus précisément, l'invention a pour objet une mémoire programmable effaçable électriquement de type "FLASH EEPROM" telle que revendiquée dans la revendication 1.

Le document **US-A-5 281 868** révèle l'utilisation d'un incrémenteur pour calculer à partir de l'adresse d'une colonne en défaut l'adresse de la colonne physiquement voisine. Par contre, ce document ne traite pas du cas où les éléments redondants seraient eux-mêmes en défaut. Il ne suggère donc pas que les incrémenteurs puissent être remplacés par des moyens de calcul ayant la possibilité de fournir une sortie identique à l'entrée.

Le document **GB-A-2 254 173** concerne les mémoires "FLASH" munies de rangées redondantes et traite du problème de la programmation avant effacement ("preconditionning") des rangées défectueuses, en particulier les rangées voisines en court-circuit. Afin de permettre leur programmation en parallèle, il est prévu un décodeur spécialement conçu pour systématiquement sélectionner à la fois deux lignes de mot voisines.

Comme pour le document US, le cas où les éléments redondants seraient en défaut n'est pas abordé. Par ailleurs, ce document réalise des sélections simultanées de rangées voisines en modifiant les décodeurs et non pas comme l'invention en agissant au niveau des adresses.

Par rapport à la solution ancienne, l'invention présente l'avantage qu'une partie au moins des registres non volatiles est remplacée par des circuits normaux présentant une bien meilleure fiabilité.

Selon un mode de réalisation particulier de l'invention, les moyens de calcul comportent au moins un circuit d'incrémentation fournissant une grandeur de sortie égale à la somme d'une valeur d'entrée et d'une valeur d'incrémentation.

Le cas le plus simple est celui où l'ordre topologique des rangées et des colonnes de la mémoire suit celui des valeurs numériques des adresses correspondantes. Dans ce cas, pour remplacer plusieurs éléments voisins, le calcul des adresses pourra être effectué au moyen d'un seul circuit d'incrémentation avec une valeur d'incrémentation égale à un. De plus, un circuit d'incrémentation unique pourra être partagé entre plusieurs circuits de sélection. Il conviendra toutefois de prévoir à chaque mise sous tension de la mémoire une phase initialisation au cours de laquelle sont calculées et mémorisées successivement les valeurs d'adresse des éléments à remplacer.

Si l'on désire éviter cette phase d'initialisation, et selon un mode de réalisation particulier conforme à l'invention, le circuit de sélection comporte un circuit d'incrémentation associé à chacun des autres éléments à remplacer.

Avantageusement, le circuit d'incrémentation est formé d'un circuit logique combinatoire conçu pour effectuer la somme d'une valeur d'entrée et d'une valeur d'incrémentation fixe.

Bien entendu, pour plus de flexibilité, on pourra prévoir dans une même mémoire plusieurs circuits de sélection dont les circuits d'incrémentation sont associés à des valeurs d'incrémentation différentes.

Un type de défaut qui se produit fréquemment est celui où deux ou plusieurs lignes de mot topologiquement voisines sont en court-circuit. Comme un tel défaut peut également se produire pour des rangées redondantes, le circuit de sélection est avantageusement prévu pour que les signaux de sélection qu'il fournit sélectionnent des rangées redondantes topologiquement voisines, le circuit de sélection comportant alors un circuit d'inhibition de ces signaux de sélection.

Les défauts entre lignes pose un problème particulier dans le cas des mémoires "FLASH EEPROM" pour les raisons qui vont être exposées ci-dessous. Ce type de mémoire utilise comme cellule mémoire un transistor MOS particulier à grille flottante dont le seuil de conduction est modifiable par l'application sur ses électrodes de tensions appropriées. La programmation d'une cellule consiste à créer un seuil élevé (par exemple 6 volts) par l'application de tensions de programmation sur la grille (par exemple 12 volts) et sur le drain (par exemple 6 volts), la source étant à la masse. Cette programmation est sélective et contrôlée pour chaque transistor de la mémoire. Par convention, on dira qu'une cellule programmée mémorise la valeur 0 logique. L'effacement d'une cellule consiste à créer un seuil bas (par exemple 2 volts) par l'application d'une tension d'effacement (par exemple 10 volts) sur la source du transistor, sa grille étant à la masse et son drain placé à l'état de haute impédance. Contrairement à la programmation, une opération d'effacement est globale, ce qui signifie qu'elle s'applique à la totalité des cellules de la mémoire ou d'un secteur entier si la mémoire est organisée en plusieurs secteurs indépendants. Avec la convention précédente, une cellule effacée mémorise la valeur 1 logique. La lecture d'une cellule consiste à détecter son état de conduction. Pour cela, on applique sur sa grille une tension de lecture (par exemple 5 volts) et on compare le courant circulant dans la cellule à celui circulant dans une cellule de référence.

Lorsque l'on veut effectuer une opération d'écriture, c'est-à-dire modifier la programmation de certaines cellules de la mémoire, il faut au préalable effectuer l'effacement global du secteur concerné. Toutefois, du fait de la nature globale de l'effacement, il est nécessaire auparavant de procéder à une programmation contrôlée de chaque cellule du secteur considéré de façon à limiter les dérives et dispersions des valeurs de seuil après l'effacement global. Cette programmation avant effacement est réalisée par l'exécution d'un algorithme spécifique qui commande l'adressage et contrôle la programmation de chacune des cellules du secteur. Bien entendu, ces opérations s'appliquent également aux cellules redondantes et éventuellement aux cellules défectueuses.

La programmation d'une cellule donnée consiste à sélectionner la rangée à laquelle elle appartient en appliquant la tension de programmation des grilles sur la ligne de mot associée. D'autre part, on sélectionne la colonne de cette cellule en appliquant la tension de programmation des drains sur la ligne de bit correspondante. Les autres rangées et colonnes ne sont pas sélectionnées, avec en particulier comme conséquence que les autres lignes de mot sont reliées à la masse. Dans ces conditions, si plusieurs lignes de mot sont en court-circuit (il s'agit le plus souvent de deux lignes voisines topologiquement), la programmation avant effacement des cellules appartenant aux rangées correspondantes ne s'effectue pas normalement et les seuils obtenus après effacement risquent d'être trop bas (cellules déplétées). Ce problème sera évité si l'on prévoit de sélectionner simultanément les lignes de mot en court-circuit lorsqu'on effectue les opérations de programmation avant effacement.

Selon un aspect particulier de l'invention, cette sélection simultanée appliquée aux rangées redondantes topologiquement voisines pourra être facilement réalisée en prévoyant que les moyens de calcul du circuit de sélection sont commandables pour fournir sélectivement une valeur identique à sa valeur d'entrée.

L'invention a également pour objet une mémoire programmable effaçable électriquement de type "FLASH EEPROM" comportant une pluralité de circuits de sélection tels que définis précédemment.

D'autres aspects et avantages de l'invention apparaîtront dans la suite de la description en référence aux figures.
- La figure 1 est un schéma d'ensemble d'une mémoire comportant des éléments redondants.
- La figure 2 représente les moyens de sélection des rangées de la mémoire de la figure 1.
- La figure 3 représente une matrice de cellules mémoire utilisant des transistors à grille flottante.
- La figure 4 est une représentation détaillée d'un circuit de sélection selon l'invention.
- La figure 5 représente un exemple de réalisation des moyens de calcul pour la mise en oeuvre de l'invention.

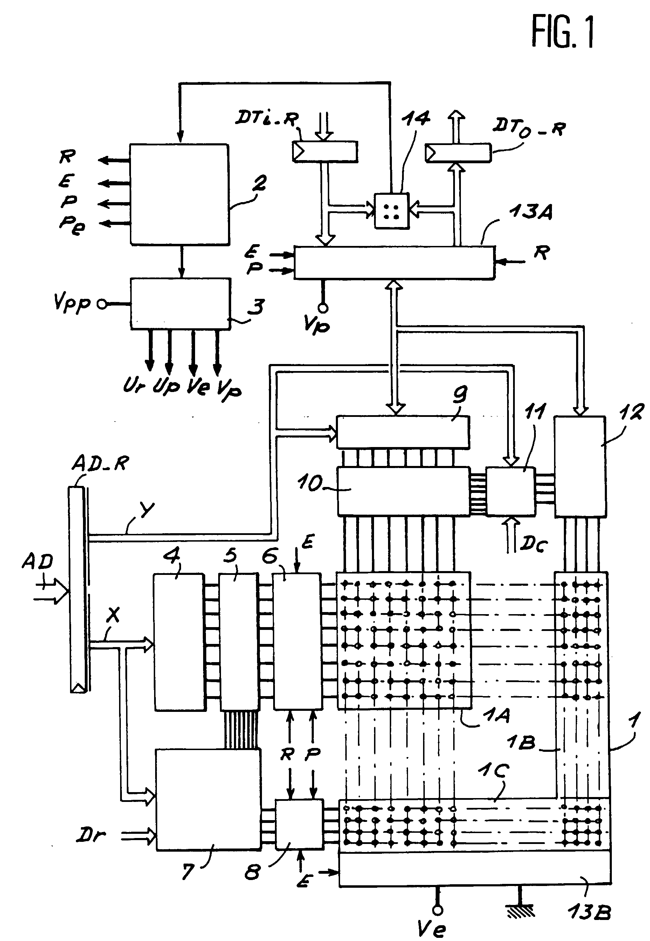

La figure 1 représente les principaux éléments constitutifs d'une mémoire dans laquelle peuvent être utilisés des circuits de sélection selon l'invention. A titre d'exemple non limitatif, la mémoire représentée est de type "FLASH EEPROM".

Outre les circuits d'interface et de maintenance non représentés, la mémoire est essentiellement constituée d'une matrice 1 de points mémoires organisés en rangées et en colonnes, d'un circuit de commande 2 et d'un générateur 3 de tensions d'alimentation. Le circuit de commande 2 est une unité programmée, par exemple du type "PLA", qui pilote l'ensemble des circuits de la mémoire comme par exemple le générateur 3. Le circuit 2 a principalement pour rôle de contrôler les opérations de lecture, d'effacement et de programmation au moyen de signaux de commande R, E, P ou Pe transmis aux différents circuits impliqués.

Le générateur 3 est chargé de fournir, à partir des tensions d'alimentation et de programmation Vpp externes, les différents potentiels Vr, Up, Vp, Ve nécessaires aux opérations de lecture, de programmation et d'effacement.

La mémoire est adressée par une adresse courante AD reçue de l'extérieur et chargée par le circuit d'interface dans un registre d'adresse AD-R. Les données échangées avec l'extérieur transitent par l'intermédiaire d'un registre de données d'entrée DTi-R pour l'écriture et d'un registre de données de sortie DTo-R pour la lecture. Les poids forts X de l'adresse AD constituent l'adresse de rangée qui sert à définir la rangée à sélectionner lors d'une opération de lecture ou d'écriture. Les poids faibles Y de l'adresse AD constituent l'adresse de colonne servant à définir la colonne à sélectionner.

La matrice 1 comporte une matrice principale ainsi qu'un ensemble de rangées redondantes 1C et un ensemble de colonnes redondantes 1D, Ces rangées et colonnes redondantes sont prévues pour remplacer des rangées et des colonnes dans lesquelles des cellules sont reconnues défaillantes au cours des opérations de tests.

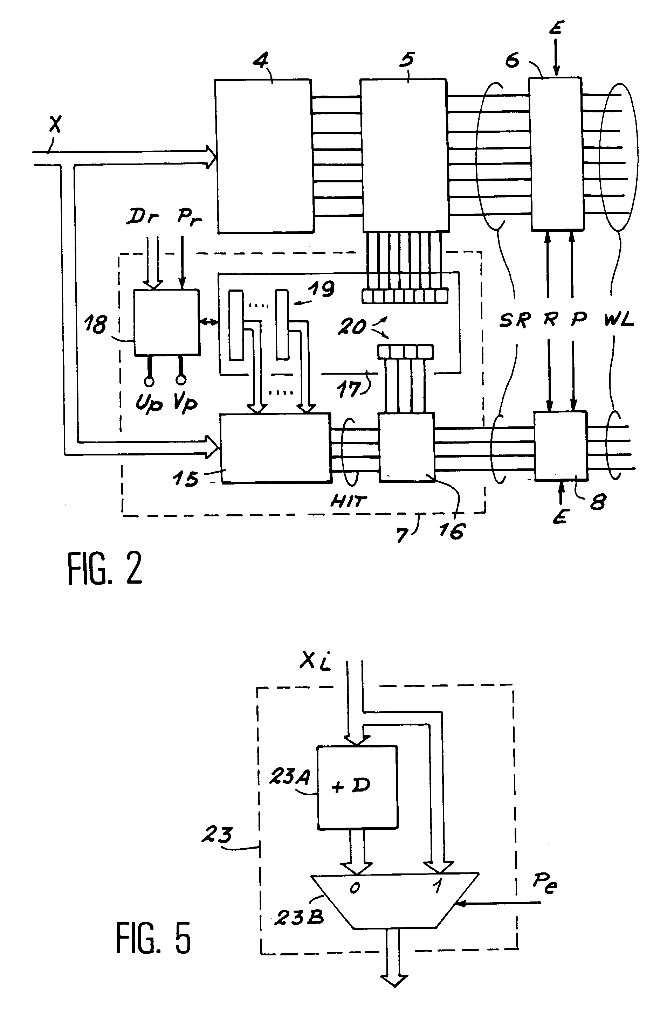

De façon classique, les rangées de la matrice principale sont sélectionnables en fonction de l'adresse de rangée X au moyen d'un décodeur de rangées 4 qui fournit des signaux de sélection à un circuit d'alimentation et d'amplification 6 par l'intermédiaire d'un circuit d'inhibition 5. Le circuit d'amplification 6 est prévu pour appliquer sur les lignes de mot de la matrice 1A les tensions appropriées pour les opérations de lecture, d'effacement ou de programmation. Le circuit d'inhibition des rangées 5 a pour but de désactiver les rangées défectueuses sélectionnées par un circuit de reconfiguration des rangées 7. Le circuit 7 qui sera décrit plus en détail en référence à la figure 2 joue également le rôle de circuit de sélection des rangées redondantes 1C et commande un circuit d'amplification 8 servant à alimenter les lignes de mot associées à ces rangées, de façon analogue au circuit 6.

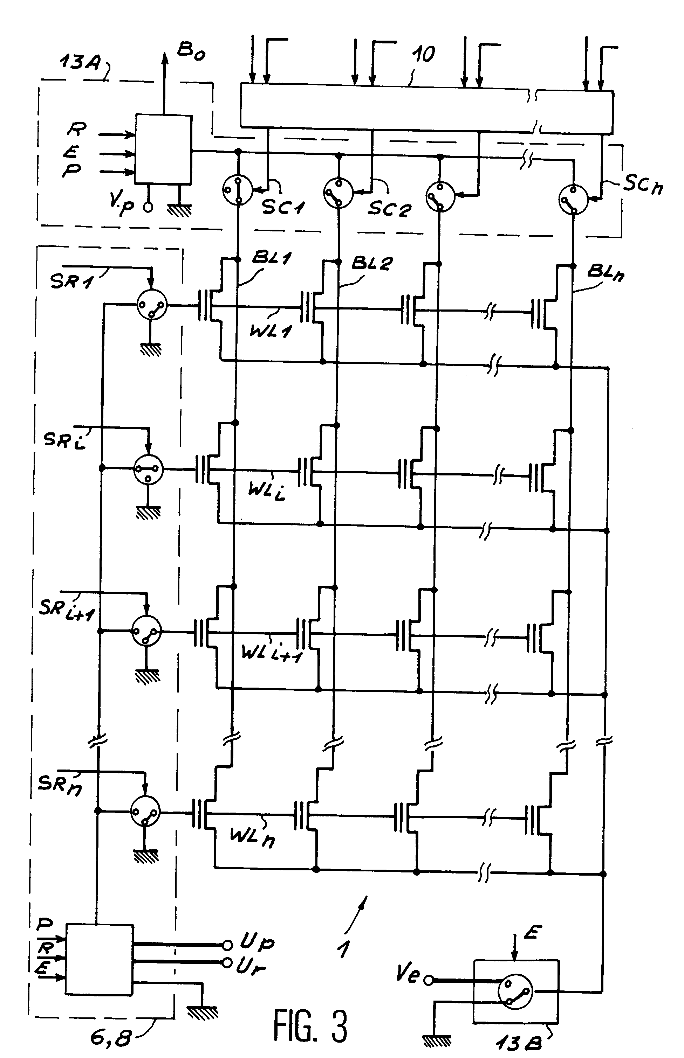

Les colonnes de la matrice principale sont sélectionnées en fonction de l'adresse de colonne Y au moyen d'un décodeur de colonnes 9 relié à un circuit de sélection des colonnes 10 commandé par un circuit de reconfiguration des colonnes 11. Le circuit 11 commande également un circuit de sélection 12 des colonnes redondantes 1B. Les circuits de sélection 10, 12 fournissent des signaux de sélection qui conditionnent l'application de tensions appropriées sur les lignes de bit correspondantes lors des opérations de lecture ou d'écriture. Ces tensions sont fournies par les circuits 13A et 13B dans des conditions qui seront décrites plus en détail en référence à la figure 3. Le circuit 13A comporte en outre des moyens d'amplification pour la lecture. Afin de pouvoir lire et écrire simultanément plusieurs bits d'un même mot associés à plusieurs colonnes, on prévoit généralement plusieurs amplificateurs de lecture et plusieurs circuits d'écriture fonctionnant en parallèle.

Un comparateur 14 est relié en entrées aux amplificateurs de lecture et au registre de données d'entrée DTi-R de façon à informer le circuit de commande 2 du bon déroulement des opérations de programmation des cellules mémoire. Le résultat de cette comparaison est pris en compte par le circuit de commande 2 pour adapter l'exécution de son algorithme de programmation.

La figure 2 représente l'ensemble des moyens de sélection des rangées de la matrice 1 et montre plus en détail le circuit de reconfiguration 7. Le circuit 7 comprend une mémoire de reconfiguration 17 constituée essentiellement d'une mémoire d'adresses 19 et de cellules d'invalidation 20. Ces éléments de mémoire sont formés au moyen de cellules non volatiles associées à des moyens de lecture (non représentés). Ces cellules sont en outre programmables par un circuit de programmation 18. La mémoire d'adresses 19 est constituée d'une pluralité de registres prévus pour contenir chacun une valeur particulière d'adresse de rangées correspondant à une rangée défectueuse de la matrice principale 1A. Les cellules d'invalidation 20 sont associées respectivement aux rangées de la matrice 1 et leurs états logiques constituent des indicateurs d'inhibition des rangées associées. La programmation des éléments 19 et 20 par le circuit 18 s'effectue en réponse à une commande de programmation Pr, en fonction de données de reconfiguration Dr délivrées par les circuits de maintenance de la mémoire.

Les états des cellules d'invalidation des rangées de la matrice principale 1A sont transmis au circuit d'inhibition 5 mentionné précédemment. Le circuit 5 fournit les signaux SR de sélection des rangées au circuit d'alimentation 6 des lignes de mot WL. La sélection des rangées redondantes est effectuée au moyen d'un décodeur 15 et d'un circuit d'inhibition 16 avantageusement réalisés au moyen de circuits de sélection selon l'invention. Le décodeur 15 reçoit en entrée l'adresse de rangée courante X ainsi que les valeurs d'adresse particulières contenues dans la mémoire d'adresses 19. En fonction de ces données, le décodeur 15 fournit au circuit d'inhibition 16 des signaux de comparaison HIT qui constituent des signaux de présélection des rangées redondantes. Comme pour la matrice principale, le circuit d'inhibition 16 reçoit les indicateurs d'inhibition représentatifs des états des cellules d'invalidation associées aux rangées redondantes et fournit les signaux de sélection SR correspondants. Comme pour la matrice principale, les signaux SR commandent le circuit d'alimentation 8 des lignes de mot WL.

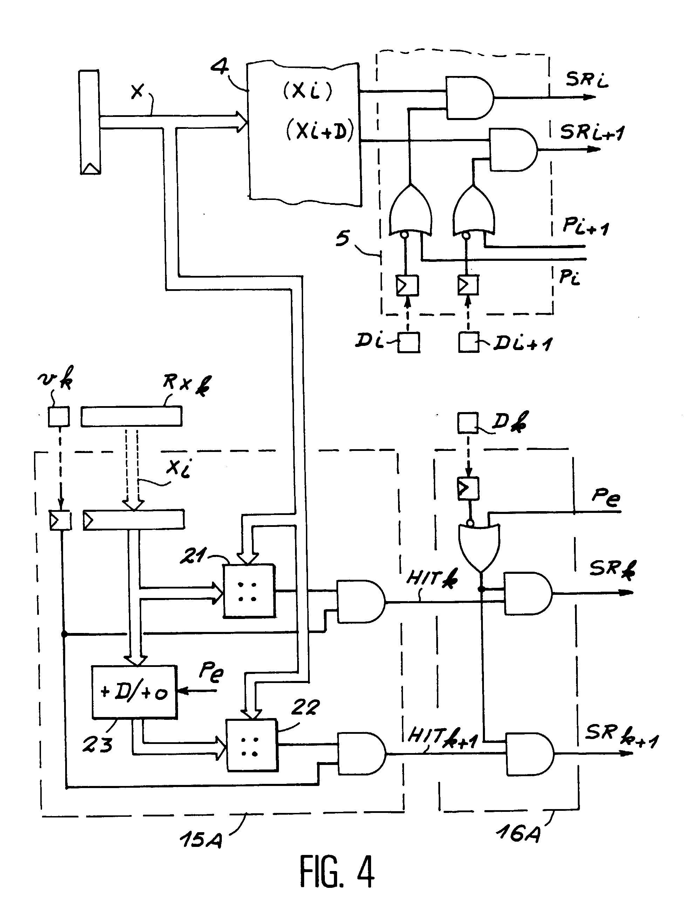

La programmation de la mémoire de reconfiguration 17 repose sur le principe suivant. Initialement, toutes les cellules d'invalidation 20 et celles constituant la mémoire d'adresses 19 sont effacées. Lorsqu'une rangée de la matrice principale est détectée comme défectueuse, sa cellule d'invalidation est programmée. La valeur particulière de l'adresse de cette rangée est alors chargée dans un des registres de la mémoire d'adresses 19 par une programmation sélective des cellules de ce registre. Additionnellement, une cellule réservée de ce registre est programmée de façon à constituer un indicateur de validité de l'adresse associée. Cette valeur particulière d'adresse sera ensuite utilisée par le décodeur 15 de la façon qui sera décrite ultérieurement en référence à la figure 4. S'il s'avère qu'une des rangées redondantes ainsi mise en service est elle-même défectueuse, sa cellule d'invalidation est alors programmée de façon à informer le circuit d'inhibition 16.

En variante, les cellules d'invalidation des rangées de la matrice principale peuvent être supprimées à condition de prévoir une inhibition globale de toutes les rangées de la matrice principale, cette inhibition globale étant provoquée par l'activation de l'un quelconque des signaux de comparaison HIT.

Les moyens de sélection des colonnes peuvent être réalisés de façon tout-à-fait analogue au schéma précédent. Il n'en sera donc pas donné une description spécifique.

Avant d'exposer de façon plus détaillée le circuit de sélection selon l'invention, il convient de rappeler la structure et l'organisation des matrices de transistors à grille flottante utilisées dans les mémoires de type "FLASH EEPROM". La figure 3 représente une telle structure dans le cas simple d'un accès par mots d'un seul bit. Les cas d'accès par mots de plusieurs bits s'en déduisent aisément.

Les sources des transistors sont toutes reliées entre elles et sont alimentées par un circuit d'alimentation des sources 13B fournissant le potentiel de masse lors des opérations de lecture et de programmation ou bien un potentiel d'effacement Ve (de l'ordre de 10 volts) lors des opérations d'effacement. Chaque rangée est commandée par une ligne de mot WL₁, WLᵢ, WLᵢ₊₁, WLₙ reliée à chacune des grilles de commande des transistors de la rangée. Les lignes de mot sont alimentées par un circuit d'alimentation 6, 8 commandé par les signaux de sélection des rangées SR1, SRᵢ, SRᵢ₊₁, SRₙ. Pour les rangées non sélectionnées, telles que la première rangée, le circuit d'alimentation 6, 8 applique le potentiel de masse aux lignes de mot associées. Pour la rangée sélectionnée (rangée i), le circuit 6, 8 applique sur la ligne de mot correspondante WLᵢ le potentiel Up (de l'ordre de 12 volts) dans le cas d'une programmation, le potentiel Ur (de l'ordre de 5 volts) dans le cas d'une lecture ou le potentiel de masse dans le cas d'un effacement. Les drains des transistors de chaque colonne sont reliés à une ligne de bit associée BL1, BL2, ..., BLn. Ces lignes de bit sont reliées au circuit de lecture et d'écriture 13A commandé par les signaux de sélection des colonnes SC₁, SC₂, ..., SCₙ fournis par le circuit de sélection des colonnes 10. Les lignes de bit des colonnes non sélectionnées sont placées à l'état de haute impédance, tandis que celle de la colonne sélectionnée (la première colonne) est reliée à un amplificateur de lecture fournissant une donnée binaire Bo dans le cas d'une lecture ou bien reçoit un potentiel de programmation Vp (de l'ordre de 6 volts) dans le cas d'une programmation ou bien est placée à l'état de haute impédance dans le cas d'un effacement.

De la description qui précède, on peut constater que les opérations de lecture et de programmation sont sélectives pour chaque transistor de la matrice alors que les opérations d'effacement concernent la totalité des transistors. Pour les raisons indiquées précédemment, le caractère global des opérations d'effacement nécessite une programmation préalable de chacun des transistors de la matrice. La programmation d'un de ces transistors implique donc l'application sur sa ligne de mot (par exemple WLᵢ) du potentiel de programmation Up, son drain étant alimenté par la tension Vp. Par ailleurs, les autres lignes de mot (par exemple WLᵢ₊₁) sont normalement reliées à la masse. Or, si la ligne de mot sélectionnée WLᵢ est mal isolée et se trouve en court-circuit avec une autre ligne de mot, généralement voisine, elle ne reçoit pas un potentiel de programmation convenable. Il en résulte que les transistors des deux rangées dont les lignes de mot sont en court-circuit seront mal programmés (seuil de conduction trop bas) et risquent après l'effacement global d'être déplétés (seuil de tension négatif) et donc de conduire même s'ils ne sont pas sélectionnés.

Il en résulte que la tension présente sur une ligne de bit lors d'une lecture risque de ne plus être représentative de l'état de conduction du transistor sélectionné. Pour remédier à ce problème, la solution consiste à imposer une programmation en parallèle des transistors des rangées ayant leurs lignes de mot en court-circuit. Ceci peut être réalisé en modifiant en conséquence le fonctionnement du dernier étage du décodeur de rangées. Nous verrons ultérieurement comment cette modification peut être réalisée simplement grâce au circuit de sélection selon l'invention qui va maintenant être décrit plus en détail en référence à la figure 4.

Le circuit de sélection est essentiellement constitué d'un décodeur de rangées redondantes 15A et d'un circuit d'inhibition 16A. Pour simplifier l'exposé, le circuit représenté à la figure 4 est prévu pour sélectionner seulement deux rangées redondantes topologiquement voisines (k, k+1) sélectionnables par les signaux SRₖ et SRₖ₊₁. En complément, la figure 4 représente également les parties du décodeur 4 et du circuit d'inhibition 5 relatives à deux rangées (i, i+1) de la matrice principale sélectionnables par les signaux SRᵢ et SRᵢ₊₁.

Le décodeur 15A du circuit de sélection comporte un premier comparateur 21 recevant en entrées l'adresse de rangée courante X et la valeur particulière d'adresse de rangée contenue dans le registre RXₖ de la mémoire d'adresses 19. Cette valeur particulière est par exemple l'adresse Xi de la rangée i de la matrice principale. Pour simplifier la logique du décodeur 15A, le registre RXₖ comporte une cellule vk dont l'état logique sert d'indicateur de validité des données contenues dans le registre RXₖ. La valeur particulière Xᵢ est d'autre part appliquée à l'entrée de moyens de calcul 23 capables d'effectuer la somme de sa valeur d'entrée et d'une valeur d'incrémentation D. Un second comparateur 22 reçoit en entrées l'adresse courante X et la valeur calculée par les moyens de calcul 23. Ainsi, lorsque la valeur particulière contenue dans le registre RXₖ est validée par l'état de la cellule vk, les circuits de comparaison 21 et 22 fournissent respectivement des signaux de comparaison HITₖ et HITₖ₊₁ transmis au circuit d'inhibition 16A. A la condition que l'indicateur d'invalidation Dₖ associé aux rangées redondantes k et k+1 soit inactif, les signaux HITₖ et HITₖ₊₁ constituent respectivement les signaux de sélection SRₖ et SRₖ₊₁ des rangées redondantes k et k+1.

Ainsi en choisissant comme valeur d'incrémentation D l'écart entre les adresses de deux rangées (par exemple les rangées voisines i et i+1) de la matrice principale, le circuit de sélection sélectionnera les rangées redondantes k et k+1 respectivement à la place des rangées i et i+1 de la matrice principale. Bien entendu, les rangées i et i+1 auront été désactivées au préalable par la programmation des indicateurs d'invalidation correspondant Dᵢ et Dᵢ₊₁.

Comme nous l'avons expliqué précédemment, un court-circuit entre deux lignes de mot (voisines) nécessite une programmation avant effacement en parallèle. Il convient donc de prévoir ce cas en autorisant l'activation des signaux de sélection malgré les indicateurs d'invalidation. Pour les rangées de la matrice principale, cette autorisation peut être réalisée au moyen de signaux de programmation avant effacement Pᵢ et Pᵢ₊₁ selon le schéma du circuit d'inhibition 5 représenté sur la figure.

Concernant les rangées redondantes, la programmation en parallèle avant effacement peut être réalisée plus simplement en prévoyant que les moyens de calcul 23 soient commandables par un signal Pe pour qu'ils fournissent une valeur de sortie identique à la valeur d'entrée. Ainsi, lorsque le signal Pe est actif, l'apparition d'une adresse courante X égale à la valeur particulière Xi provoque l'activation simultanément des signaux de comparaison HITₖ et HITₖ₊₁. Ainsi, comme l'indicateur d'invalidation Dk est désactivé par le signal Pe, les rangées k et k+1 seront sélectionnées simultanément par les signaux de sélection SRₖ et SRₖ₊₁ simultanément actifs. Bien entendu, cette possibilité de sélection simultanée de plusieurs rangées présente surtout un intérêt lorsque ces rangées sont topologiquement voisines car les cas de court-circuit entre lignes éloignées sont beaucoup plus improbables.

Le mode de réalisation qui vient d'être décrit n'est bien entendu pas limitatif. De nombreuses variantes à la portée de l'homme du métier peuvent y être apportées. En particulier, le circuit de sélection pourra être modifié pour sélectionner des rangées supplémentaires en prévoyant d'autres moyens de calcul et d'autres comparateurs. Il sera également possible de partager les moyens de calcul entre plusieurs comparateurs d'un même circuit de sélection ou de plusieurs circuits de sélection différents par des moyens de multiplexage appropriés qui seront commandés lors d'une phase d'initialisation après chaque mise sous tension de la mémoire.

Conformément au schéma de la figure 5, les moyens de calcul peuvent être avantageusement réalisés au moyen d'un circuit d'incrémentation 23A constitué d'un circuit logique câblé conçu pour fournir une valeur d'incrémentation fixe. Ce circuit 23A sera alors associé à un multiplexeur 23B commandé par le signal Pe selon le schéma représenté sur la figure.

## Revendications

1. Mémoire programmable effaçable électriquement de type "FLASH EEPROM", organisée en rangées et colonnes de cellules mémoire, un "élément" désignant une rangée ou une colonne, ladite mémoire comportant plusieurs éléments redondants (1B, 1C) sélectionnables par un au moins un circuit de sélection (15A, 16A), lesdits éléments redondants (1B, 1C) étant destinés à remplacer des éléments comportant des cellules défectueuses, lesdits éléments à remplacer étant identifiés respectivement par des valeurs particulières d'une adresse courante (X) servant à adresser lesdits éléments, une desdites valeurs particulières (Xᵢ) étant contenue dans des moyens de mémorisation (RXᵢ) non volatiles et programmables, ledit circuit de sélection (15A, 16A) comportant des moyens de calcul (23) pour calculer en fonction d'une valeur d'entrée égale à ladite valeur (Xᵢ) contenue dans lesdits moyens de mémorisation (RXᵢ) la valeur d'adresse (Xᵢ + D) d'au moins un autre élément à remplacer et des moyens de comparaison (21, 22) pour comparer ladite adresse courante (X) auxdites valeur mémorisée (Xᵢ) et valeur(s) d'adresse calculée(s) (Xᵢ + D) et pour fournir des signaux de comparaison (HITₖ, HITₖ₊₁) résultant desdites comparaisons, lesdits signaux de comparaison (HITₖ, HITₖ₊₁) conditionnant l'élaboration de signaux de sélection (SRₖ, SRₖ₊₁) d'éléments redondants associés, lesdits moyens de calcul (23) de ladite mémoire étant commandables pour fournir sélectivement une valeur identique à ladite valeur d'entrée.

2. Mémoire selon la revendication 1, caractérisée en ce que lesdits moyens de calcul (23) comportent au moins un circuit d'incrémentation (23A) fournissant une grandeur de sortie égale à la somme d'une valeur d'entrée et d'une valeur d'incrémentation (D).

3. Mémoire selon la revendication 2, caractérisée en ce que le circuit de sélection (15A, 16A) comporte un circuit d'incrémentation (23A) associé à chacun desdits autres éléments à remplacer.

4. Mémoire selon l'une des revendications 2 ou 3, caractérisée en ce que ledit circuit d'incrémentation (23A) est formé d'un circuit logique combinatoire conçu pour effectuer la somme d'une valeur d'entrée et d'une valeur d'incrémentation (D) fixe.

5. Mémoire selon l'une des revendications 1 à 4, caractérisée en ce que lesdits signaux de sélection (SRₖ, SRₖ₊₁) sélectionnent des rangées redondantes topologiquement voisines et en ce que ledit circuit de sélection comporte un circuit d'inhibition (16A) desdits signaux de sélection (SRₖ, SRₖ₊₁).

6. Mémoire selon l'une des revendications 1 à 5, caractérisée en ce que chaque valeur particulière mémorisée (Xᵢ) est associée à un indicateur d'invalidation (Dₖ) contenu dans une cellule mémoire programmable et non volatile, en ce que lorsque ledit indicateur d'invalidation est dans un premier état logique, lesdits signaux de sélection (SRₖ, SRₖ₊₁) sont identiques respectivement auxdits signaux de comparaison (HITₖ, HITₖ₊₁), en ce que lorsque ledit indicateur d'invalidation (Dₖ) est dans un second état logique, lesdits signaux de sélection (SRₖ, SRₖ₊₁) sont inhibés sauf dans le cas où une opération de programmation avant effacement de la mémoire est effectuée, auquel cas lesdits moyens de calcul (23) sont commandés pour fournir une valeur identique à ladite valeur d'entrée.

## Patentansprüche

1. Elektrisch löschbarer, programmierbarer Speicher des Typs "FLASH EEPROM", der in Zeilen und Spalten von Speicherzellen organisiert ist, wobei ein "Element" eine Zeile oder eine Spalte bezeichnet, wobei der Speicher mehrere redundante Elemente (1B, 1C) enthält, die durch wenigstens eine Auswahlschaltung (15A, 16A) auswählbar sind, wobei die redundanten Elemente (1B, 1C) dazu vorgesehen sind, Elemente mit fehlerhaften Zellen zu ersetzen, wobei die zu ersetzenden Elemente durch besondere Werte einer momentanen Adresse (X), die dazu dienen, die Elemente zu adressieren, identifiziert werden, wobei einer dieser besonderen Werte (Xᵢ) in nichtflüchtigen und programmierbaren Speichermitteln (RXᵢ) enthalten ist, wobei die Auswahlschaltung (15A, 16A) Rechenmittel (23) zum Berechnen des Adressenwertes (Xᵢ + D) wenigstens eines anderen zu ersetzenden Elements in Abhängigkeit von einem Eingangswert, der gleich dem in den Speichermitteln (RXᵢ) enthaltenen Wert (Xᵢ) ist, sowie Vergleichsmittel (21, 22) zum Vergleichen der momentanen Adresse (X) mit dem gespeicherten Wert (Xᵢ) und mit einem oder mehreren berechneten Adressenwerten (Xᵢ + D) und zum Liefern von Vergleichssignalen (HITₖ, HITₖ₊₁), die sich aus den Vergleichen ergeben, enthält, wobei die Vergleichssignale (HITₖ, HITₖ₊₁) die Bewertung der Auswahlsignale (SRₖ, SRₖ₊₁) von zugeordneten redundanten Elementen konditionieren, wobei die Rechenmittel (23) des Speichers in der Weise steuerbar sind, daß sie selektiv einen Wert liefern, der mit dem Eingangswert übereinstimmt.

2. Speicher nach Anspruch 1, dadurch gekennzeichnet, daß die Rechenmittel (23) wenigstens eine Inkrementierungsschaltung (23A) enthalten, die eine Ausgangsgröße liefert, die gleich der Summe aus einem Eingangswert und einem Inkrementierungswert (D) ist.

3. Speicher nach Anspruch 2, dadurch gekennzeichnet, daß die Auswahlschaltung (15A, 16A) eine Inkrementierungsschaltung (23A) enthält, die jedem der anderen zu ersetzenden Elemente zugeordnet ist.

4. Speicher nach einem der Ansprüche 2 oder 3, dadurch gekennzeichnet, daß die Inkrementierungsschaltung (23A) aus einer kombinatorischen Logikschaltung gebildet ist, die so beschaffen ist, daß sie die Summe aus einem Eingangswert und einem festen Inkrementierungswert (D) bildet.

5. Speicher nach einem der Ansprüche 1 bis 4, dadurch gekennzeichnet, daß die Auswahlsignale (SRₖ, SRₖ₊₁) redundante Zeilen wählen, die topologisch benachbart sind, und daß die Auswahlschaltung eine Sperrschaltung (16A) für die Auswahlsignale (SRₖ, SRₖ₊₁) enthält.

6. Speicher nach einem der Ansprüche 1 bis 5, dadurch gekennzeichnet, daß der gespeicherte besondere Wert (Xᵢ) einem Invalidierungssanzeiger (Dₖ) zugeordnet ist, der in einer programmierbaren und nichtflüchtigen Speicherzelle enthalten ist, daß dann, wenn sich der Invalidierungsanzeiger in einem ersten logischen Zustand befindet, die Auswahlsignale (SRₖ, SRₖ₊₁) mit den entsprechenden Vergleichssignalen (HITₖ, HITₖ₊₁) jeweils übereinstimmen, daß dann, wenn sich der Invalidierungsanzeiger (Dₖ) in einem zweiten logischen Zustand befindet, die Auswahlsignale (SRₖ, SRₖ₊₁) außer in dem Fall, in dem eine Programmierungsoperation vor der Löschung des Speichers erfolgt, gesperrt sind, wobei in diesem Fall die Rechenmittel (23) so gesteuert werden, daß sie einen Wert liefern, der mit dem Eingangswert übereinstimmt.

## Claims

1. Electrically erasable programmable memory of the "FLASH EEPROM" type, organised in rows and columns of memory cells, an "element" designating a row or a column, the said memory having several redundant elements (1B, 1C) which can be selected by at least one selection circuit (15A, 16A), the said redundant elements (1B, 1C) being designed to replace elements having defective cells, the said elements to be replaced being identified respectively by particular values of a current address (X) serving to address the said elements, one of the said particular values (Xᵢ) being contained in non-volatile programmable storage means (RXᵢ), the said selection circuit (15A, 16A) including calculation means (23) for calculating, as a function of an input value equal to the said value (Xᵢ) contained in the said storage means (RXᵢ), the address value (Xᵢ + D) of at least one other element to be replaced, and comparison means (21, 22) for comparing the said current address (X) with the said stored value (Xᵢ) and a calculated address value or values (Xᵢ + D) and for supplying comparison signals (HITₖ, HITₖ₊₁) resulting from the said comparisons, the said comparison signals (HITₖ, HITₖ₊₁) determining the production of selection signals (SRₖ, SRₖ₊₁) for associated redundant elements, the said calculation means (23) of the said memory being able to be controlled so as to supply selectively a value identical to the said input value.

2. Memory according to Claim 1, characterised in that the said calculation means (23) include at least one incrementation circuit (23A) supplying an output quantity equal to the sum of an input value and an incrementation value (D).

3. Memory according to Claim 2, characterised in that the selection circuit (15A, 16A) includes an incrementation circuit (23A) associated with each of the said other elements to be replaced.

4. Memory according to one of Claims 2 or 3, characterised in that the said incrementation circuit (23A) is formed by a combinatorial logic circuit designed to effect the sum of an input value and a fixed incrementation value (D).

5. Memory according to one of Claims 1 to 4, characterised in that the said selection signals (SRₖ, SRₖ₊₁) select topologically adjacent redundant rows and in that the said selection circuit includes a circuit (16A) inhibiting the said selection signals (SRₖ, SRₖ₊₁).

6. Memory according to one of Claims 1 to 5, characterised in that each particular value stored (Xᵢ) is associated with an invalidation indicator (Dₖ) contained in a programmable non-volatile memory cell, in that, when the said invalidation indicator is in a first logic state, the said selection signals (SRₖ, SRₖ₊₁) are identical respectively to the said comparison signals (HITₖ, HITₖ₊₁), in that, when the said invalidation indicator (Dₖ) is in a second logic state, the said selection signals (SRₖ, SRₖ₊₁) are inhibited except in the case where an operation of programming before erasure of the memory is effected, in which case the said calculation means (23) are controlled so as to supply a value identical to the said input value.
